(19) **Europäisches Patentamt / European Patent Office / Office européen des brevets**

(11)  **EP 3 894 877 B1**

(12)  # FASCICULE DE BREVET EUROPEEN

(45) Date de publication et mention
de la délivrance du brevet:
**27.09.2023 Bulletin 2023/39**

(21) Numéro de dépôt: **19839399.3**

(22) Date de dépôt: **12.12.2019**

(51) Classification Internationale des Brevets (IPC):
***G01R 31/392*** (2019.01)     ***G01R 31/396*** (2019.01)

(52) Classification Coopérative des Brevets (CPC):
**G01R 31/392; G01R 31/396;** G01R 31/3828

(86) Numéro de dépôt international:
**PCT/FR2019/053042**

(87) Numéro de publication internationale:
**WO 2020/120911 (18.06.2020 Gazette 2020/25)**

(54) **PROCÉDÉ DE DÉTERMINATION DE L'ÉTAT DE SANTÉ DES CELLULES D'UNE BATTERIE**

VERFAHREN ZUR BESTIMMUNG DES GESUNDHEITSZUSTANDS DER ZELLEN EINER BATTERIE

METHOD FOR DETERMINING THE STATE OF HEALTH OF THE CELLS OF A BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2018 FR 1872807**

(43) Date de publication de la demande:
**20.10.2021 Bulletin 2021/42**

(73) Titulaire: **Commissariat à l'Energie Atomique et aux Energies Alternatives
75015 Paris (FR)**

(72) Inventeur: **CROUZEVIALLE, Bruno
38054 Grenoble Cedex 9 (FR)**

(74) Mandataire: **Cabinet Beaumont
4, Place Robert Schuman
B.P. 1529
38025 Grenoble Cedex 1 (FR)**

(56) Documents cités:
EP-A1- 3 276 364     WO-A1-2017/133760
FR-A1- 2 976 677     US-A1- 2015 260 795

**Description**

La présente demande de brevet revendique la priorité de la demande de brevet français FR18/72807.

Domaine technique

La présente description concerne le domaine des batteries électriques de façon générale, et vise plus particulièrement la détermination de l'état de santé ou état de vieillissement des cellules d'une batterie.

Technique antérieure

Une batterie électrique est un groupement de plusieurs cellules rechargeables reliées en série et/ou en parallèle entre deux noeuds ou bornes de fourniture de tension.

Dans certaines applications, on souhaite pouvoir estimer, pour chaque cellule d'une batterie, un indicateur représentatif du vieillissement de la cellule, généralement appelé SOH, de l'anglais "State of Health" pour état de santé. A un instant donné de la vie d'une cellule, le SOH peut être défini comme étant le rapport de la capacité de la cellule (c'est-à-dire la charge maximale qu'est capable de stocker et délivrer la cellule) à l'instant considéré, sur une capacité de référence de la cellule, par exemple sa capacité nominale (c'est-à-dire la capacité indiquée par le constructeur), ou sa capacité mesurée à l'état neuf.

La connaissance du SOH de chaque cellule peut par exemple permettre d'identifier des cellules défectueuses pour les isoler ou les remplacer, ou de recaler ou réajuster les jauges d'état de charge des cellules pour tenir compte du vieillissement des cellules.

La demande de brevet EP3276364 (DD17299/B15316) précédemment déposée par le demandeur décrit une méthode d'estimation du SOH des différentes cellules d'une batterie à partir d'une unique phase de décharge ou de charge complète de la batterie.

Cette méthode nécessite toutefois de mémoriser l'évolution de la tension aux bornes de chacune des cellules de la batterie tout au long de la phase de décharge ou de charge de la batterie. Ceci peut s'avérer contraignant et poser des difficultés dans certaines applications, notamment lorsque le nombre de cellules de la batterie est important, dans la mesure où la quantité de données à mémoriser est alors relativement élevée.

Le document US2015/260795 décrit une autre méthode d'estimation du SOH d'une cellule de batterie. Résumé de l'invention

Un mode de réalisation prévoit un procédé de détermination de l'état de santé des cellules d'une batterie comme défini dans la revendication 1.

Selon un mode de réalisation, pour chaque cellule, à l'étape e), la valeur QCi représentative de la capacité de la cellule est calculée selon la formule suivante :

[Math. 8]

$$QCi = C\_interp\_i * QCi\_lim$$

Selon un mode de réalisation, le procédé comporte en outre, après l'étape e), la fourniture, pour chaque autre cellule de la batterie, d'un indicateur d'état de santé de la cellule calculé en tenant compte de ladite valeur QCi représentative de la capacité de la cellule.

Selon un mode de réalisation, le procédé comprend en outre :

préalablement à ladite phase de décharge, une étape de charge de la batterie jusqu'à un seuil de pleine charge ; ou
préalablement à ladite phase de charge, une étape de décharge de la batterie jusqu'à un seuil de décharge.

Selon un mode de réalisation, l'étape préalable de charge ou de décharge de la batterie comporte un équilibrage des cellules de la batterie.

Un autre mode de réalisation prévoit un procédé de revalorisation de cellules de batterie usagées comportant une étape de diagnostic des cellules mettant en oeuvre un procédé tel que défini ci-dessus.

Selon un mode de réalisation, le procédé comporte en outre une étape de sélection de cellules dont l'indicateur d'état de santé satisfait une condition prédéfinie, et une étape d'assemblage des cellules sélectionnées en une nouvelle batterie.

## Brève description des dessins

Ces caractéristiques et leurs avantages, ainsi que d'autres, seront exposés en détail dans la description suivante de modes de réalisation particuliers faite à titre non limitatif en relation avec la figure jointe :

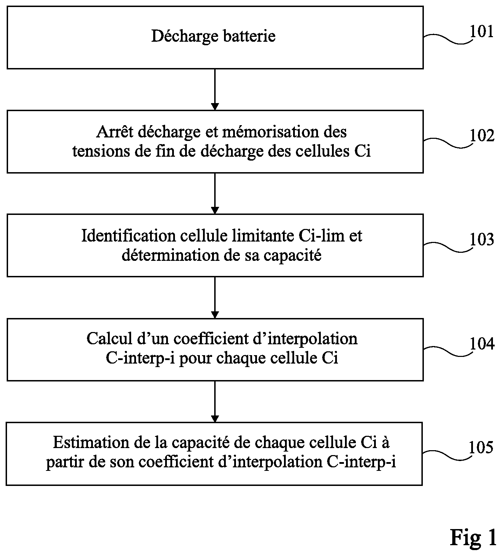

la figure 1 est un logigramme illustrant, sous forme de blocs, un exemple d'un procédé de détermination de l'état de santé des cellules d'une batterie selon un mode de réalisation.

## Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses utilisations qui peuvent être faites du SOH des cellules d'une batterie n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

On s'intéresse ici plus particulièrement à la détermination du SOH des cellules d'une batterie comportant plusieurs cellules reliées en série entre une borne positive et une borne négative de la batterie. Les cellules de la batterie sont de préférence identiques aux dispersions de fabrication et de vieillissement près. Chaque cellule peut comporter une unique cellule élémentaire de type pile, accumulateur, etc., ou plusieurs cellules élémentaires reliées en série et/ou en parallèle entre une borne positive et une borne négative de la cellule. Les cellules élémentaires sont par exemple des cellules au lithium, par exemple des cellules de type lithium-ion, lithium-métal-polymère, etc. Plus généralement, les modes de réalisation décrits s'appliquent à toutes ou à la plupart des technologies de cellules élémentaires de batterie connues.

La figure 1 est un logigramme illustrant, sous forme de blocs, un exemple d'un procédé de détermination de l'état de santé des cellules d'une batterie selon un mode de réalisation.

On considère dans cet exemple une batterie (non détaillée sur les figures) comportant n cellules C1, ..., Cn reliées en série entre une borne positive et une borne négative de la batterie, avec n entier supérieur ou égal à 2, par exemple supérieur ou égal à 3.

Un outil de diagnostic (non détaillé sur les figures) est connecté à la batterie, cet outil comportant n capteurs de tension connectés respectivement aux bornes des n cellules Ci de la batterie, avec i entier allant de 1 à n. Chaque capteur de tension est adapté à mesurer la tension Ui aux bornes de la cellule Ci à laquelle il est associé. L'outil de diagnostic peut en outre comporter un compteur coulométrique ou un intégrateur de courant connecté à au moins une borne de la batterie, ou tout autre élément permettant de mesurer ou d'estimer la charge extraite de la batterie lors d'une phase de décharge de la batterie. L'outil de diagnostic comporte en outre des moyens de mémorisation (mémoire, registre, etc.) d'au moins un jeu de n valeurs de tension Ui mesurées respectivement aux bornes des n cellules Ci de la batterie à un instant donné. L'outil de diagnostic peut en outre comporter une unité de traitement pouvant comporter un microprocesseur. En pratique, l'outil de diagnostic peut faire partie d'un dispositif électronique de gestion de la batterie intégré à la batterie, généralement désigné par le terme BMS, de l'anglais "Battery Management System", destiné à mettre en oeuvre des fonctions diverses telles que des fonctions d'équilibrage des cellules, des fonctions de protection, etc. En effet, les composants susmentionnés de l'outil de diagnostic sont des composants que l'on retrouve classiquement dans un dispositif de gestion de batterie de type BMS. A titre de variante, l'outil de diagnostic peut être un dispositif externe à la batterie, destiné à être connecté à la batterie lors d'une phase de diagnostic des cellules de la batterie. Dans une autre variante, l'outil de diagnostic peut être partiellement intégré à la batterie et partiellement externe à la batterie. Par exemple, les capteurs de tension de l'outil de diagnostic peuvent être internes à la batterie, et le dispositif de traitement mettant en oeuvre la méthode décrite à partir des valeurs de tension fournies par les capteurs peut être externe à la batterie. L'outil de diagnostic est configuré pour mettre en oeuvre le procédé de la figure 1 de détermination de l'état de santé des cellules de la batterie.

Le procédé de la figure 1 comprend une étape 101 au cours de laquelle la batterie est soumise à une décharge complète, par exemple à courant constant et à température ambiante constante. Préalablement à l'étape 101, si la batterie n'est pas déjà chargée, une étape de recharge résiduelle de la batterie à son niveau de pleine charge peut être mise en oeuvre. Lors de cette recharge résiduelle, un équilibrage de fin de charge est de préférence réalisé, de façon à ce que les cellules de la batterie présentent toutes sensiblement le même niveau de tension au début de la phase de décharge complète. Les techniques susceptibles d'être utilisées pour réaliser un tel équilibrage de fin de charge sont connues de l'homme du métier et ne seront pas détaillées.

Pendant la phase de décharge complète, l'outil de diagnostic surveille la tension Ui aux bornes de chaque cellule Ci de façon à interrompre la décharge lorsqu'une première cellule Ci de la batterie atteint un seuil de tension basse VL prédéfini, correspondant par exemple à un seuil critique de décharge à ne pas dépasser sous peine d'endommager la cellule. A titre d'exemple, la tension limite basse VL est définie par le fabricant des cellules. La tension VL est par exemple identique pour toutes les cellules de la batterie.

A titre d'exemple, tout au long de la phase de décharge, l'outil de diagnostic lit périodiquement les tensions Ui aux bornes des différentes cellules de la batterie, et vérifie à chaque lecture si l'une des cellules Ci n'a pas atteint son niveau de tension de fin de décharge VL. A chaque itération, les n tensions Ui sont par exemple lues en parallèle (c'est-à-dire simultanément) et mémorisées dans un registre ou une mémoire de l'outil de diagnostic, avant d'être comparées une à une au seuil VL par l'unité de traitement. Si aucune des n tensions Ui mesurées n'est inférieure ou égale au seuil VL, les n valeurs de tensions Ui mémorisées peuvent être écrasées à l'itération suivante (c'est-à-dire remplacées par les n nouvelles valeurs de tension Ui lues) . Ainsi, dans cet exemple, seul le dernier jeu de tensions Ui lu par l'outil de diagnostic est conservé en mémoire.

L'outil de diagnostic acquiert en outre, à chaque lecture, la valeur de la charge Q extraite de la batterie depuis le début de la phase de décharge. A titre d'exemple, à chaque itération, seule la dernière valeur lue de la charge extraite Q est conservée en mémoire par l'outil de diagnostic.

Lors d'une étape 102, lorsqu'une première cellule Ci de la batterie atteint son niveau de tension de fin de décharge VL, la décharge de la batterie est interrompue. Le dernier jeu de tensions Ui lu par l'outil de diagnostic est alors conservé en mémoire en vue d'une étape ultérieure d'estimation des capacités des n cellules Ci. La valeur Qtot de la charge extraite de la batterie depuis le début de la phase de décharge est également mémorisée.

Lors d'une étape 103, la cellule Ci ayant atteint en premier son seuil de décharge VL et ayant ainsi provoqué l'arrêt de la décharge de la batterie, est identifiée par l'outil de diagnostic comme étant la cellule limitante Ci_lim de la batterie.

Lors de l'étape 103, l'outil de diagnostic détermine la capacité réelle QCi_lim de la cellule limitante Ci_lim comme correspondant à la charge totale Qtot extraite de la batterie pendant la phase de décharge, qui définit également la capacité de la batterie. Connaissant cette capacité QCi_lim = Qtot, le SOH SOHCi_lim de la cellule limitante Ci_lim peut être calculé, par exemple comme étant le rapport de la capacité QCi_lim sur une capacité de référence de la cellule.

Lors d'une étape 104, pour chacune des cellules Ci de la batterie à l'exception de la cellule limitante Ci_lim, l'outil de diagnostic calcule un coefficient d'interpolation C_interp_i spécifique à la cellule, fonction de la tension de fin de décharge Ui de la cellule, du régime de décharge C_rate de la batterie (courant de décharge appliqué à la batterie), ainsi que des tensions de fin de décharge d'une ou plusieurs autres cellules de la batterie.

Dans cet exemple, le coefficient d'interpolation C_interp_i est fonction de la tension de fin de décharge Ui de la cellule, du régime de décharge C_rate des cellules de la batterie, d'une valeur Umin définie comme étant la tension de fin de décharge la plus faible du jeu de tensions de fin de décharge Ui mémorisé à l'étape 102, c'est-à-dire dans cet exemple la tension de fin de décharge de la cellule limitante, égale au seuil VL de fin de décharge défini pour les cellules de la batterie, d'une valeur Umax définie comme étant la tension de fin de décharge la plus élevée du jeu de tensions de fin de décharge Ui mémorisé à l'étape 102, et d'une valeur Umoy définie comme étant la moyenne des tensions de fin de décharge Ui mémorisées à l'étape 102.

Par régime de décharge C_rate, on entend ici le rapport entre le courant de décharge Idch de la batterie, en ampères, pendant la phase de décharge à l'étape 101 (ou la valeur moyenne du courant de décharge dans le cas où le courant de décharge n'est pas constant pendant la phase de décharge 101) et la capacité initiale Qinit d'une cellule élémentaire de la batterie, c'est-à-dire sa capacité à l'état neuf, en ampère-heure (par exemple la capacité nominale de la cellule telle que fournie par le fabriquant).

Plus particulièrement, dans cet exemple, le coefficient d'interpolation C_interp_i est défini comme suit :

[Math. 9]

$$C\_interp\_i = (K + B * D * C + B * D * E - B * A)/K$$

où A, B, C, D, E et K sont des paramètres définis comme suit :

[Math. 10]

$$K = (Umoy^2 * (1 + C\_rate))/(2 * C\_rate)$$

[Math. 11]

$$A = Umax - Ui$$

[Math. 12]

$$B = Ui - Umin$$

[Math. 13]

$$C = Ui/Umin$$

[Math. 14]

$$D = Ui/Umax$$

[Math. 15]

$$E = (Umax - Umin)/Ui$$

Lors d'une étape 105, pour chaque cellule Ci de la batterie à l'exception de la cellule limitante Ci_lim, une fois le coefficient d'interpolation C_interp_i de la cellule déterminé, l'outil de diagnostic calcule une valeur QCi représentative de la capacité réelle de la cellule Ci à partir du coefficient d'interpolation C_interp_i de la cellule, selon la formule suivante :

[Math. 16]

$$QCi = C\_interp\_i * QCi\_lim$$

Connaissant la capacité réelle QCi de la cellule, son SOH peut être calculé par l'outil de diagnostic, par exemple comme étant le rapport de la capacité QCi sur une capacité de référence de la cellule (par exemple la capacité nominale de la cellule telle que fournie par le fabriquant).

A titre de variante, l'indicateur d'état de santé SOHCi de la cellule peut être calculé directement à partir de l'indicateur d'état de santé SOHCi_lim de la cellule limitante par la formule suivante :

[Math. 17]

$$SOHCi = C\_interp\_i * SOHCi\_lim$$

Un avantage du procédé décrit en relation avec la figure 1 est qu'il permet d'estimer l'état de santé des différentes cellules d'une batterie à partir d'une unique phase de décharge complète de la batterie, et ce sans avoir à acquérir et enregistrer les courbes de décharge des différentes cellules de la batterie pendant la phase de décharge et sans avoir à faire appel à des bibliothèques de courbes de caractérisation.

Les essais réalisés ont montré qu'avec ce procédé, pour des régimes de décharge C_rate inférieurs ou égaux à 1C, on obtient une erreur maximale inférieure à plus ou moins 3 % sur la mesure des capacités individuelles (et donc sur le SOH) des cellules d'une batterie de 88 cellules connectées en série, par rapport à une mesure réalisée par la méthode décrite dans la demande de brevet EP3276364 susmentionnée. Cette erreur augmente légèrement lorsque le régime de décharge augmente, mais reste acceptable (plus ou moins 7 % pour un régime de décharge C_rate égal à 2C).

Cette méthode peut par exemple être mise en oeuvre par un dispositif de gestion intégré à la batterie, pendant le cycle de vie normal de la batterie, pour surveiller l'état de santé des différentes cellules de la batterie, par exemple en vue de planifier d'éventuelles opérations de maintenance de la batterie, pour optimiser l'utilisation de la batterie, ou pour prévenir un éventuel disfonctionnement.

Une autre application de la méthode proposée concerne le diagnostic des cellules d'une batterie usagée en vue de leur revalorisation. A titre d'exemple, une fois les indicateurs d'état de santé des différentes cellules déterminés par la méthode proposée, on peut prévoir de prélever les cellules dont le SOH est supérieur à un seuil, par exemple en vue de les réassembler dans une nouvelle batterie. Les autres cellules sont par exemple recyclées par récupération des métaux les constituants. On notera que si les batteries usagées à revaloriser ne présentent pas une architecture série, ces dernières peuvent être démontées et leurs cellules réassemblées en série pour mettre en oeuvre la méthode de diagnostic décrite ci-dessus.

Une autre application de la méthode proposée concerne le diagnostic de cellules neuves préalablement à leur assemblage dans une batterie. A titre d'exemple, les cellules peuvent être montées en série lors d'une phase de diagnostic préalable à l'assemblage de la batterie. Les cellules peuvent ensuite être assemblées selon une topologie série et/ou parallèle en tenant compte des dispersions de SOH identifiées lors de la phase de diagnostic pour choisir les emplacements des différentes cellules dans la batterie.

Des modes de réalisation particuliers ont été décrits. Diverses variantes et modifications apparaîtront à l'homme de l'art. En particulier, bien que l'on ait décrit ci-dessus, en relation avec la figure 1, une méthode de diagnostic réalisée à partir d'une phase de décharge complète de la batterie, précédée le cas échant d'une charge résiduelle de la batterie jusqu'à son niveau de pleine charge, une méthode similaire peut être mise en oeuvre à partir d'une décharge résiduelle de la batterie depuis un niveau de charge quelconque jusqu'à son niveau de décharge, suivie d'une phase de recharge complète de la batterie. Comme dans l'exemple décrit en relation avec la figure 1, la décharge résiduelle (étape 101) est alors interrompue lorsqu'une première cellule atteint son seuil de décharge VL, et les tensions $U_i$ de fin de décharge des n cellules $C_i$ sont mémorisées (étape 102). A ce stade, la capacité de la cellule limitante (étape 103) ne peut toutefois pas encore être déterminée. Il faut en effet attendre la fin de la phase subséquente de recharge complète de la batterie pour estimer la capacité totale $Q_{tot}$ de la batterie et donc la capacité de la cellule limitante. Une fois la recharge complète terminée et la capacité de la cellule limitante déterminée, les étapes 104 et 105 sont mises en oeuvre de façon identique ou similaire à ce qui a été décrit ci-dessus, en se basant sur la capacité de la cellule limitante mesurée à l'issue de la phase de recharge complète de la batterie et sur les tensions de fin de décharge $U_i$ mémorisées à l'issue de l'étape de décharge résiduelle de la batterie pour calculer les coefficients d'interpolation $C\_interp\_i$ puis les capacités réelles $QC_i$ des différentes cellules.

Dans une autre variante, plutôt que d'estimer les capacités $QC_i$ des cellules $C_i$ à partir des tensions $U_i$ mesurées à la fin d'une phase de décharge (complète ou résiduelle) de la batterie, on peut prévoir d'adapter le procédé de diagnostic décrit ci-dessus pour calculer les capacités $QC_i$ des cellules $C_i$ à partir des tensions $U_i$ mesurées à la fin d'une phase de recharge de la batterie.

A titre d'exemple, un procédé similaire à ce qui a été décrit en relation avec la figure 1 peut être mis en oeuvre à partir d'une phase de charge complète de la batterie. Pour cela, la batterie peut être au préalable déchargée jusqu'à son seuil de décharge. Un équilibrage de fin de décharge peut en outre être réalisé de façon que, au début de la phase de charge complète de la batterie, les différentes cellules $C_i$ de la batterie aient sensiblement le même niveau de tension. Pendant la phase de recharge complète de la batterie, l'outil de diagnostic lit périodiquement la tension $U_i$ aux bornes de chaque cellule de la batterie, et mesure la charge injectée dans la batterie depuis le début de la phase de recharge. Lorsqu'une première cellule ou cellule limitante $C_{i\_lim}$ atteint son niveau de pleine charge, correspondant par exemple à la tension maximale que peut supporter la cellule sans dégradation, la recharge de la batterie est interrompue, et les valeurs des tensions $U_i$ des n cellules de la batterie sont mémorisées. La charge $Q_{tot}$ injectée dans la batterie depuis le début de la phase de recharge correspond à la capacité réelle de la cellule $C_{i\_lim}$, qui définit la capacité de la batterie. A partir de cette valeur $Q_{tot}$ et des tensions de fin de charge $U_i$ des cellules de la batterie, de façon similaire à ce qui a été décrit en relation avec la figure 1 (étapes 104 et 105), pour chaque cellule $C_i$ à l'exception de la cellule limitante $C_{i\_lim}$, l'outil de diagnostic calcule un coefficient d'interpolation $C\_interp\_i$ spécifique à la cellule puis estime la capacité $QC_i$ de la cellule en multipliant la capacité $QC_{i\_lim}$ de la cellule limitante par ce coefficient d'interpolation.

Une méthode de diagnostic similaire peut être mise en oeuvre à partir d'une recharge résiduelle de la batterie depuis un niveau de décharge quelconque, suivie d'une phase de décharge complète de la batterie. Dans ce cas, la recharge résiduelle est interrompue lorsqu'une première cellule atteint son niveau de pleine charge, et les tensions $U_i$ de fin de recharge des n cellules $C_i$ sont mémorisées. A ce stade, la capacité de la cellule limitante ne peut toutefois pas encore être déterminée. Il faut attendre la fin de la phase subséquente de décharge complète de la batterie pour connaître la capacité totale $Q_{tot}$ de la batterie et donc la capacité de la cellule limitante. Une fois la décharge complète terminée et la capacité de la cellule limitante déterminée, les étapes 104 et 105 sont mises en oeuvre de façon identique ou similaire à ce qui a été décrit ci-dessus, en se basant sur la capacité de la cellule limitante mesurée à l'issue de la phase de décharge complète de la batterie et sur les tensions de fin de décharge $U_i$ mémorisées à l'issue de l'étape de recharge résiduelle de la batterie pour calculer les coefficients d'interpolation $C\_interp\_i$ puis les capacités réelles $QC_i$ des différentes cellules.

Par ailleurs, les modes de réalisation décrits ne se limitent pas aux exemples susmentionnés dans lesquels la fin de la phase de décharge complète ou de recharge complète de la batterie est conditionnée à un passage de la tension de la cellule limitante par un seuil bas (VL) ou haut (non référencé sur les figures). Plus généralement, dans la méthode proposée, la décharge complète ou la charge complète de la batterie peut être interrompue dès lors qu'une condition de fin de décharge ou de fin de charge prédéfinie est satisfaite par une première cellule de la batterie.

**Revendications**

1. Procédé de détermination de l'état de santé des cellules (Ci) d'une batterie comportant une pluralité de cellules (Ci) reliées en série, ce procédé comportant les étapes suivantes :

   a) pendant une phase (101) de décharge ou de charge de la batterie, mesurer la tension Ui aux bornes de chaque cellule (Ci) ;
   b) lorsqu'une première cellule (Ci_lim) atteint une condition prédéfinie de fin de décharge ou de fin de charge, interrompre (102) la décharge ou la charge de la batterie et mémoriser, pour chaque cellule (Ci), la tension Ui de la cellule à la fin de la phase de décharge ou de charge de la batterie ;
   c) déterminer (103) la charge Qtot extraite de la batterie ou injectée dans la batterie entre le début et la fin d'une phase de décharge complète ou de charge complète de la batterie et en déduire une valeur QCi_lim représentative de la capacité de la première cellule ;
   d) calculer (104), pour chaque autre cellule de la batterie, un coefficient d'interpolation C_interp_i à partir d'une valeur C_rate représentative du régime de décharge ou de charge de la batterie, et des tensions de fin de décharge ou de fin de charge Ui mémorisées à l'étape b) ; et
   e) déterminer (105), pour chaque autre cellule de la batterie, à partir de la valeur QCi_lim déterminée à l'étape c) et du coefficient d'interpolation C_interp_i calculé pour la cellule à l'étape d), une valeur QCi représentative de la capacité de la cellule,
   dans lequel, pour chaque autre cellule (Ci), le coefficient d'interpolation C_interp_i calculé à l'étape d) (104) est fonction de la tension Ui de la cellule mémorisée à l'étape b), de la valeur C_rate, d'une valeur Umin définie comme étant la tension la plus faible du jeu de tensions Ui mémorisé à l'étape b), d'une valeur Umax définie comme étant la tension la plus élevée du jeu de tensions Ui mémorisé à l'étape b), et d'une valeur Umoy définie comme étant la moyenne des tensions Ui mémorisées à l'étape b),
   et dans lequel, pour chaque cellule (Ci), le coefficient d'interpolation C_interp_i calculé à l'étape d) (104) est défini comme suit :

   [Math. 18]

   $$C\_interp\_i = (K + B * D * C + B * D * E - B * A)/K$$

   où A, B, C, D, E et K sont des paramètres définis comme suit :

   [Math. 19]

   $$K = (Umoy^2 * (1 + C\_rate))/(2 * C\_rate)$$

   [Math. 20]

   $$A = Umax - Ui$$

   [Math. 21]

   $$B = Ui - Umin$$

[Math. 22]

$$C = Ui/Umin$$

[Math. 23]

$$D = Ui/Umax$$

[Math. 24]

$$E = (Umax - Umin)/Ui$$

**2.** Procédé selon la revendication 1, dans lequel, pour chaque cellule (Ci), à l'étape e) (105), la valeur QCi représentative de la capacité de la cellule est calculée selon la formule suivante :

[Math. 25]

$$QCi = C\_interp\_i * QCi\_lim$$

**3.** Procédé selon la revendication 1 ou 2, comportant en outre, après l'étape e), la fourniture, pour chaque autre cellule (Ci) de la batterie, d'un indicateur d'état de santé de la cellule calculé en tenant compte de ladite valeur QCi représentative de la capacité de la cellule.

**4.** Procédé selon l'une quelconque des revendications 1 à 3, comprenant en outre :

préalablement à ladite phase de décharge (101), une étape de charge de la batterie jusqu'à un seuil de pleine charge ; ou
préalablement à ladite phase de charge, une étape de décharge de la batterie jusqu'à un seuil de décharge.

**5.** Procédé selon la revendication 4, dans lequel l'étape préalable de charge ou de décharge de la batterie comporte un équilibrage des cellules (Ci) de la batterie.

**6.** Procédé de revalorisation de cellules de batterie usagées comportant une étape de diagnostic des cellules mettant en oeuvre un procédé selon l'une quelconque des revendications 1 à 5.

**7.** Procédé selon la revendication 6 dans sa dépendance à la revendication 3, comportant en outre une étape de sélection de cellules (Ci) dont l'indicateur d'état de santé satisfait une condition prédéfinie, et une étape d'assemblage des cellules sélectionnées en une nouvelle batterie.

**Patentansprüche**

**1.** Ein Verfahren um den Zustand von Zellen (Ci) einer Batterie zu beurteilen, die eine Vielzahl von in Reihe geschalteten Zellen (Ci) aufweist, wobei das Verfahren die folgenden Schritte aufweist:

a. während einer Lade- oder Entladephase (101) der Batterie, Messen der Spannung Ui an den Anschlüssen jeder der Zellen (Ci);
b. wenn eine erste Zelle (Ci_lim) eine vorbestimmte Bedingung zum Ende-des-Ladens oder Ende-des-Entladens erreicht, Anhalten (102) des Batterie-Ladens oder -Entladens und Speichern, für jede Zelle (Ci) der Spannung Ui der Zelle am Ende der Lade- oder Entladephase der Batterie,
c. Berechnen (103) der Ladung Qtot, die aus der Batterie entnommen wurde oder in die Batterie eingespeist wurde zwischen dem Beginn und dem Ende einer vollständigen Ladephase oder vollständigen Entladephase der Batterie, und Herleiten des Wertes QCi_lim, der repräsentativ für die Kapazität der ersten Zelle ist,
d. Berechnen (104), für jede einzelne der anderen Zellen der Batterie, eines Interpolationskoeffizienten C-interp_i aus einem Wert C_rate, der repräsentativ für das Lade- oder Entladesystem der Batterie ist und aus den Spannungen Ui zum Ende-des-Ladens oder Ende-des-Entladens die in Schritt b) gespeichert wurden, und

e. Berechnen (105), für jede einzelne der anderen Zellen der Batterie, aus dem Wert QCi_lim aus Schritt c) und aus dem Interpolationskoeffizienten C_interp_i der für die Zelle in Schritt d) berechnet wurde, des Werts QCi, der repräsentativ für die Kapazität der Zelle ist, wobei, für jede einzelne der anderen Zellen (Ci), der Interpolationskoeffizienten C-interp_i, der in Schritt d) berechnet wurde (104) eine Funktion der Folgenden Werte ist, der Spannung Ui der Zelle, wie sie in Schritt b) gespeichert wurde, des C_rate Wertes, eines Wertes Umin, der als die niedrigste Spannung des Satzes von Spannungen Ui definiert ist, die in Schritt b) gespeichert wurden, eines Wertes Umax der als die höchste Spannung des Satzes von Spannungen Ui definiert ist, die in Schritt b) gespeichert wurden, und eines Wertes Umoy der als ein Durchschnitt des Satzes von Spannungen Ui definiert ist, die in Schritt b) gespeichert wurden,

und wobei, für jede Zelle (Ci), der Interpolationskoeffizient C-interp_i, der in Schritt d) berechnet wurde (104) definiert ist als:

[Math. 18]

$$C\_interp\_i = (K + B * D * C + B * D * E - B * A)/K$$

wobei A, B, C, D, E und K Parameter sind, die wie folgt definiert sind:

[Math. 19]

$$K = (Umoy^2 * (1 + C\_rate))/(2 * C\_rate)$$

[Math. 20]

$$A = Umax - Ui$$

[Math. 21]

$$B = Ui - Umin$$

[Math. 22]

$$C = Ui/Umin$$

[Math. 23]

$$D = Ui/Umax$$

[Math. 24]

$$E = (Umax - Umin)/Ui$$

2. Ein Verfahren nach Anspruch 1, wobei, für jede Zelle (Ci), bei Schritt e) (105), der Wert QCi, der repräsentativ für die Kapazität der Zelle ist, mit der folgenden Formel berechnet wird:

[Math. 25]

$$QCi = C\_interp\_i * QCi\_lim$$

3. Ein Verfahren nach Anspruch 1 oder 2, ferner aufweisend, nach Schritt e), Bereitstellen jeder einzelnen der anderen Zellen (Ci) der Batterie einer Anzeige des Zustands der Zelle, der berechnet wird unter Berücksichtigung des Werts QCi, der repräsentativ für die Kapazität der Zelle ist.

**4.** Ein Verfahren nach einem der Ansprüche 1 bis 3, ferner aufweisend:
vor der Entladephase (101), eine Ladephase der Batterie bis zu einem Voll-Lade-Schwellenwert; oder vor der Ladephase, einer Entladephase der Batterie bis zu einem Entlade-Schwellenwert.

**5.** Ein Verfahren nach Anspruch 4, wobei die vorausgesetzte Lade- oder Entladephase der Batterie ein Ausgleichen bzw. Balancing der Zellen (Ci) der Batterie aufweist.

**6.** Ein Verfahren zum Umfunktionieren von Zellen einer gebrauchten Batterie, aufweisend einen Diagnoseschritt für die Zellen, wobei ein Verfahren nach einem der Ansprüche 1 bis 5 umgesetzt wird.

**7.** Ein Verfahren nach Anspruch 6 abhängig von Anspruch 3, ferner aufweisend einen Schritt zur Auswahl der Zellen (Ci) deren Anzeige des Zustands einer vorbestimmten Bedingung entspricht, und ein Schritt zur Montage der ausgewählten Zellen als eine neue Batterie.

**Claims**

**1.** A process to evaluate the condition of the cells (Ci) of a battery that comprises a plurality of serially connected cells (Ci), wherein the process comprises the following steps:

a) during a loading or unloading stage (101) of the battery, measure the voltage Ui at the terminals of each cell (Ci);
b) when a first cell (Ci_lim) reaches a preset end-of-loading or end-of-unloading condition, stop (102) the battery loading or unloading and store, for each cell (Ci) the voltage Ui of the cell at the end of the loading or unloading stage of the battery;
c) calculate (103) the charge Qtot extracted from the battery or injected into the battery between the start and the end of a complete loading phase or of a complete unloading phase of the battery, and deduce the value QCi_lim representative of the capacitance of the first cell;
d) calculate (104) for each one of the other cells of the battery an interpolation coefficient C_interp_i from a value C_rate representative of the loading or unloading regime of the battery and from the end-of-loading or end-of-unloading voltages Ui that were stored at stage b); and
e) calculate (105), for each one of the other cells of the battery, from the value QCi_lim of stage c) and from the interpolation coefficient C_interp_i that was calculated for the cell at stage d), the value QCi representative of the capacitance of the cell, wherein, for each one of the other cells (Ci), the interpolation coefficient C_interp_i calculated at the step d) (104) is a function of the voltage Ui of the cell as stored at step b), of the C_rate value, of a value Umin that is defined as the lowest voltage of the set of voltages Ui stored at step b), of a value Umax that is defined as the highest voltage of the set of voltages Ui stored at step b), and of a value Umoy that is defined as the average of the set of voltages Ui stored at step b),
and wherein, for each cell (Ci), the interpolation coefficient C_interp_i calculated at step d) (104) is defined as:

[Math. 18]

$$C\_interp\_i = (K + B * D * C + B * D * E - B * A)/K$$

where A, B, C, D, E and K are parameters defined as:

[Math. 19]

$$K = (Umoy^2 * (1 + C\_rate))/(2 * C\_rate)$$

[Math. 20]

$$A = Umax - Ui$$

[Math. 21]

$$B = Ui - Umin$$

[Math. 22]

$$C = Ui/Umin$$

[Math. 23]

$$D = Ui/Umax$$

[Math. 24]

$$E = (Umax - Umin)/Ui$$

2. A process according to claim 1 wherein, for each cell (Ci), at step e) (105), the value QCi representative of the capacitance of the cell is calculated with the following formula:

[Math. 25]

$$QCi = C\_interp\_i * QCi\_lim$$

3. A process according to claim 1 or 2, further comprising, after step e), providing each one of the other cells (Ci) of the battery an indicator of the condition of the cell, which is calculated taking said value QCi representative of the capacitance of the cell into account.

4. A process according to any one of claims 1 to 3, further comprising:
   prior to said unloading stage (101), a loading stage of the battery up to a full-charge threshold; or prior to said loading stage, an unloading stage of the battery down to a discharge threshold.

5. A process according to claim 4, wherein the prerequisite loading or unloading stage of the battery comprises a balancing of the cells (Ci) of the battery.

6. A process to repurpose cells of used battery, comprising a diagnosis step of the cells implementing a process according to any one of claims 1 to 5.

7. A process according to claim 6 depending on claim 3, further comprising a step of selection of the cells (Ci) whose condition indicator meets a preset condition, and an assembly step for the selected cells as a new battery.

```
┌─────────────────────────────────────────────┐
│                                             │
│            Décharge batterie                │ ──~─ 101
│                                             │
└─────────────────────────────────────────────┘
                      │
                      ▼
┌─────────────────────────────────────────────┐
│      Arrêt décharge et mémorisation des     │
│   tensions de fin de décharge des cellules Ci│ ──~─ 102
│                                             │
└─────────────────────────────────────────────┘
                      │
                      ▼
┌─────────────────────────────────────────────┐
│    Identification cellule limitante Ci-lim et│
│        détermination de sa capacité         │ ──~─ 103
│                                             │
└─────────────────────────────────────────────┘
                      │
                      ▼
┌─────────────────────────────────────────────┐
│      Calcul d'un coefficient d'interpolation│
│        C-interp-i pour chaque cellule Ci    │ ──~─ 104
│                                             │
└─────────────────────────────────────────────┘
                      │
                      ▼
┌─────────────────────────────────────────────┐
│   Estimation de la capacité de chaque cellule Ci à│
│   partir de son coefficient d'interpolation C-interp-i│ ──~─ 105
│                                             │
└─────────────────────────────────────────────┘
```

Fig 1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1872807
- EP 3276364 A

- US 2015260795 A